# EUROPEAN PATENT SPECIFICATION

(11) **EP 4 234 940 B1**
(45) Date of publication and mention of the grant of the patent: **01.10.2025**
(21) Application number: 21882439.9
(22) Date of filing: 25.08.2021
(51) Int. Cl.: F04D 25/08, B23K 1/008, B23K 3/04, H05K 3/34

(54) **SOLDERING DEVICE**
LÖTVORRICHTUNG
DISPOSITIF DE BRASAGE

(30) Priority: 22.10.2020 JP 2020177089
(43) Date of publication of application: 30.08.2023
(73) Proprietor: Senju Metal Industry Co., Ltd., Tokyo 120-8555 (JP)
(72) Inventor: HIYAMA, Tsutomu, Tokyo 120-8555 (JP)
(74) Representative: Pfenning, Meinig & Partner mbB
(86) International application number: PCT/JP2021/031123
(87) International publication number: WO 2022/085298

(56) References cited:
- WO-A1-2006/013895
- JP-A- 2001 144 427
- JP-A- 2003 069 211
- JP-B1- 5 541 353

## Description

### TECHNICAL FIELD

The present invention relates to a soldering device.

### BACKGROUND ART

For soldering electronic component parts onto a circuit board, a soldering device such as a reflow device or a jet soldering device is used. For example, PTL 1 discloses a soldering device provided with a heater unit. As shown in Fig. 12 therein, the heater unit includes a nozzle cover in which suction ports are formed, blowing nozzles, and a blower. Further, gas drawn through the suction ports in the nozzle cover is spouted through the blowing nozzles. Further, as shown in Fig. 10 of PTL 1, in the heater unit, a rectangular attachment plate is arranged in a position facing the suction ports in the nozzle cover. Further, suction ports are formed in the vicinity of two opposing sides of the attachment plate to each extend along a different one of the sides. The suction ports in the attachment plate structure a part of a gas flow path provided inside the heater unit. For this reason, when the heater unit is driven, the gas drawn through the suction ports in the nozzle cover passes through the suction ports in the attachment plate.

### CITATION LIST

### PATENT LITERATURE

PTL 1: Japanese Patent No. 5541353

### SUMMARY OF INVENTION

### TECHNICAL PROBLEM

In the soldering device disclosed in PTL 1, the gas drawn through the suction ports in the nozzle cover needs to pass through the suction ports in the attachment plate in the process of reaching the blower. Further, there are differences among the distances from the suction ports in the nozzle cover to the suction ports in the attachment plate. For this reason, the flow volume of the gas drawn through certain suction ports in the nozzle cover positioned closer to the suction ports in the attachment plate tends to be larger than the flow volume of the gas drawn through certain suction ports in the nozzle cover positioned farther from the suction ports in the attachment plate. As a result, if no countermeasure is taken about this situation, there is a possibility that the flow volumes of the gas drawn through the plurality of suction ports may be non-uniform.

To cope with this situation, an object of the present disclosure is to provide a soldering device into which gas is drawn through suction ports in a nozzle cover (suction ports in a first plate) more uniformly than in the conventional device.

### SOLUTION TO PROBLEM

A soldering device according to the present disclosure is a soldering device for performing soldering and includes a blower unit for supplying gas to an object, in which the blower unit includes: a first plate in which a plurality of suction ports for drawing of the gas outside the blower unit are formed; a second plate that has a plate surface facing the plurality of suction ports; a plurality of nozzles; and a fan for supplying the gas drawn through the plurality of suction ports to the plurality of nozzles, a flow path through which the gas flows and which extends from the plurality of suction ports to go through the fan and to reach the plurality of nozzles is formed in the blower unit, and, a part of the flow path surrounds at least a part of the second plate in directions in which the plate surface extends.

### ADVANTAGEOUS EFFECTS OF INVENTION

In the soldering device according to the present disclosure, the gas is drawn through the suction ports in the first plate more uniformly than in the conventional device.

### BRIEF DESCRIPTION OF DRAWINGS

[Fig. 1] Fig. 1 is a structure diagram of a reflow oven according to a first embodiment of the present disclosure.
[Fig. 2] Fig. 2 is a structure diagram of any of the blower units shown in Fig. 1.
[Fig. 3] Fig. 3 is an arrow view taken on A-A in Fig. 2.
[Fig. 4A] Fig. 4A is a cross-sectional view taken on B-B in Fig. 2.
[Fig. 4B] Fig. 4B is a cross-sectional view showing a part of an attachment plate of a blower unit according to another embodiment of the present disclosure.
[Fig. 5] Fig. 5 is a cross-sectional view taken on C-C in Fig. 2.
[Fig. 6] Fig. 6 is an enlarged view of the part E in Fig. 2.

### DESCRIPTION OF EMBODIMENTS

Embodiments of the present invention will be described below, with reference to the drawings. In the drawings described below, some of the constituent elements that are the same as or correspond to each other will be denoted by the same reference numerals, and duplicate description thereof will be omitted.

### [First Embodiment]

### <Overall Configuration>

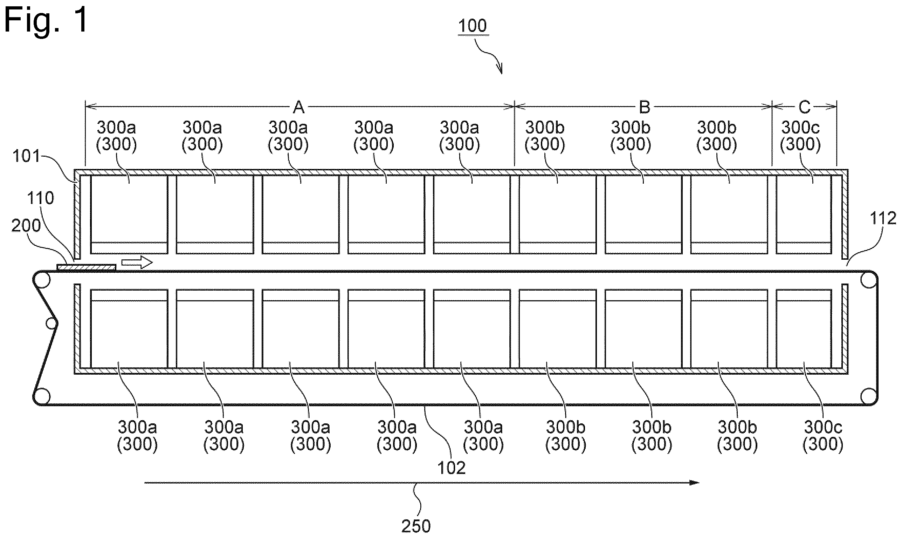

Fig. 1 is a cross-sectional view of a reflow oven 100 according to a first embodiment of the present disclosure. As shown in Fig. 1, the reflow oven 100 includes a main body part 101 and a conveyer 102 that transports a substrate 200. The reflow oven 100 is a device for soldering an electronic component part onto the substrate 200 by using a reflow method. In the reflow oven 100, while the substrate 200 on which the electronic component part is placed via a solder paste is transported from an inlet 110 to an outlet 112, the electronic component part is soldered onto the substrate 200. In this situation, the reflow oven 100 is an example of the soldering device, whereas the substrate 200 is an example of the object. Next, the reflow oven 100 will be described in detail.

A main body part 101 is divided into three zones such as a preliminary heating zone A, a main heating zone B, and a cooling zone C, in ascending order of the distance from the inlet 110. Blower units 300a, five on the top and five at the bottom, are arranged in the preliminary heating zone A. The blower units 300a in the preliminary heating zone A supply heated gas to the substrate 200 and, in an example, heat the substrate 200 up to 150 degrees to 180 degrees. As a result, the substrate 200 and the electronic component part are pre-heated. In other words, the preliminary heating zone A is a region for slowly applying the heat so that the substrate 200 and the electronic component part mounted on the substrate 200 or the like become used to the heat. Detailed configurations of the blower units 300a will be described later.

Blower units 300b, three at the top and three at the bottom, are arranged in the main heating zone B. The blower units 300b in the main heating zone B supply heated gas to the substrate 200 and, in an example, heat the substrate 200 up to 220 degrees to 260 degrees. As a result, the blower units 300b melt solder contained in the solder paste, so that the substrate 200 and the electronic component part are soldered together. In other words, the main heating zone B is a region for performing the soldering by melting solder powder in the solder paste.

Blower units 300c, one at the top and one at the bottom, are arranged in the cooling zone C. By using a known method, the blower units 300c blow cooled gas toward the substrate 200, to cool the substrate 200 on which the soldering was performed. In other words, the cooling zone C is a region for cooling the substrate 200 on which the soldering was performed.

In other embodiments, the reflow oven 100 is not limited to the configuration described above and may adopt any publicly-known configuration. For example, the inside of the reflow oven 100 according to the present embodiment may be filled with nitrogen in an example, so that the blower units 300a, 300b, and 300c are each able to spout nitrogen toward the substrate 200. However, in other embodiments, the inside of the reflow oven 100 may be filled with any known gas used by a person skilled in the art. The blower units 300a, 300b, and 300c may be configured to spout any gas used by a person skilled in the art. Further, although the reflow oven 100 according to the present embodiment includes the conveyer 102 of a single line, the reflow oven 100 in other embodiments may include a plurality of conveyers 102 arranged in parallel to one another. In that situation, the conveyers 102 may transport the substrate 200 independently of one another.

### <Blower Units>

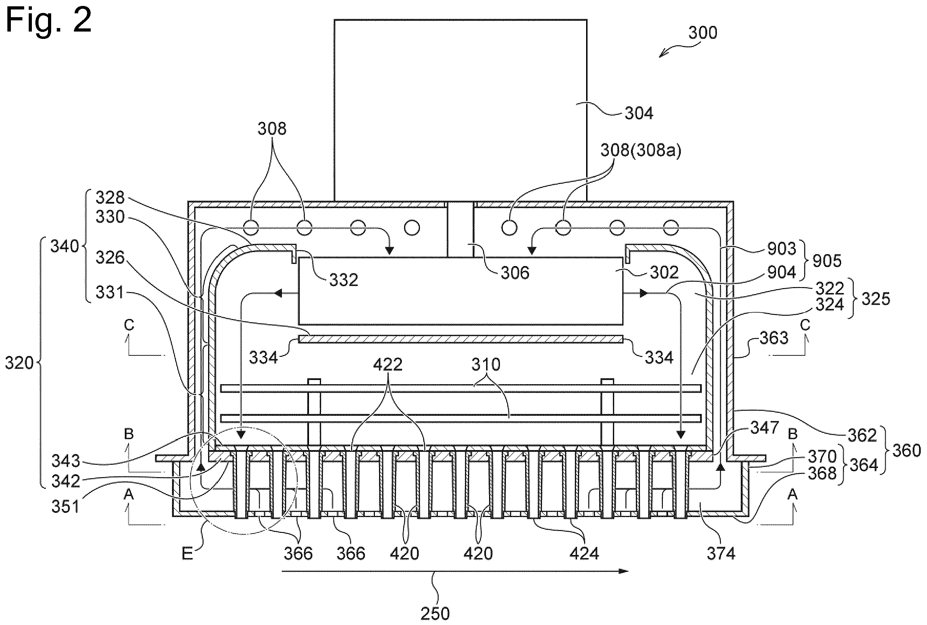

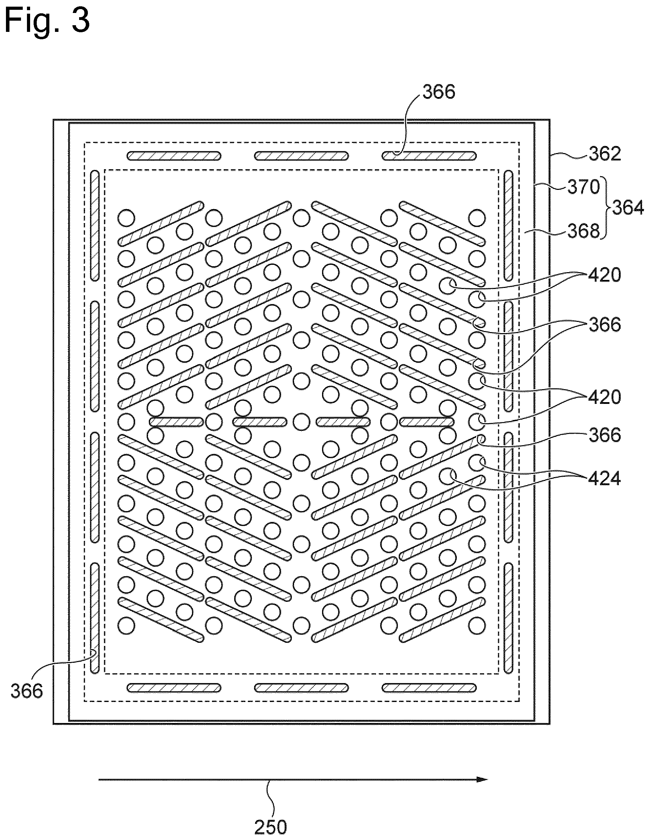

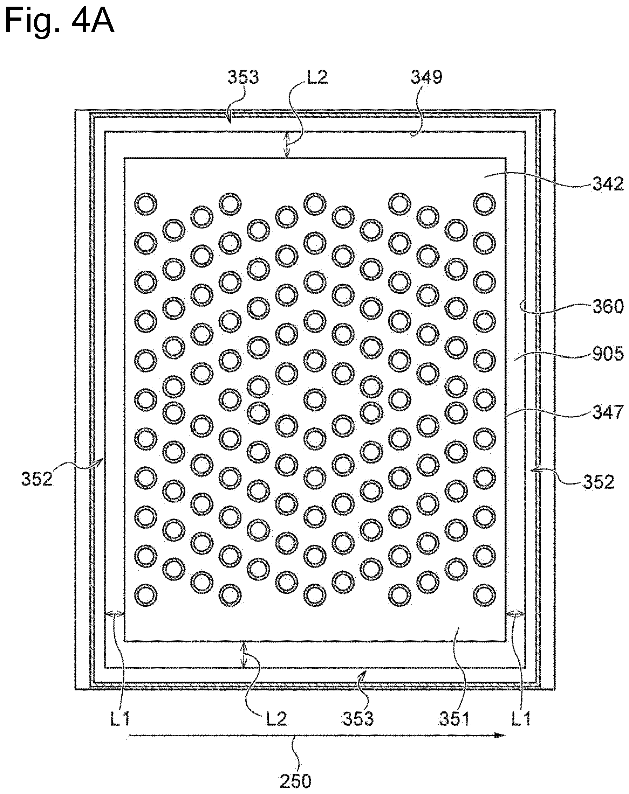

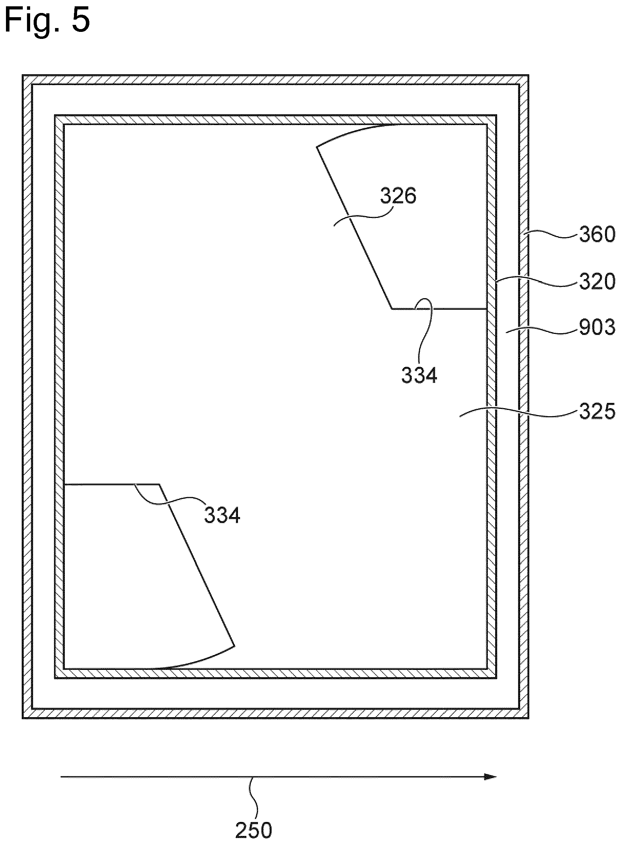

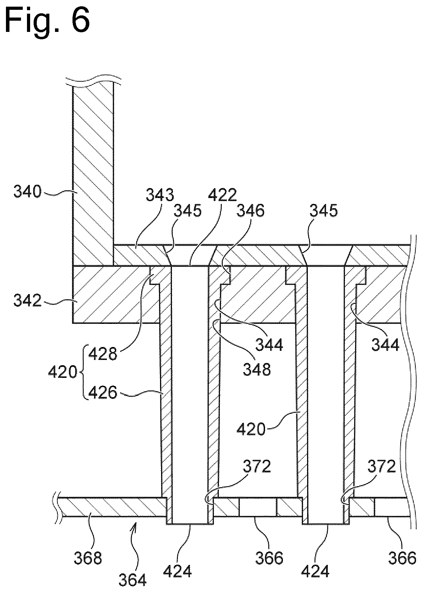

Next, the blower units 300a, the blower units 300b, and the blower units 300c will be described, with reference to Fig. 2. The blower units 300a, 300b, and 300c have the same configurations as one another, except that the temperatures of the gas supplied thereby are different. For this reason, with reference to Fig. 2 to Fig. 6, the blower units 300a, 300b, and 300c will be described, while being referred to as a blower unit 300. Fig. 2 is a structure diagram of the blower unit 300. Further, Fig. 3 is an arrow view taken on A-A in Fig. 2. Fig. 4A is a cross-sectional view taken on B-B in Fig. 2. Fig. 5 is a cross-sectional view taken on C-C in Fig. 2. Fig. 6 is an enlarged view of the part E in Fig. 2. The arrow 250 in Fig. 2 to Fig. 5 indicates the transport direction of the substrate 200 in the reflow oven 100.

As shown in Fig. 2, in an example, the blower unit 300 includes an inner case 320, an outer case 360, a plurality of nozzles 420, a fan 302, a motor 304, a rotation shaft 306, a plurality of heaters 308, and two punching metal pieces 310. Next, constituent elements of the blower unit 300 will be described.

The outer case 360 includes an outer case main body 362 and a nozzle cover 364 and houses therein the inner case 320. Further, the outer case main body 362 is a box-like body that has a substantially cuboid shape and has an opening closed by the nozzle cover 364. The nozzle cover 364 has a plate part (a first plate) 368 (see Fig. 3) having a rectangular plate-like shape and an edge part 370 extending orthogonally from the plate part 368. The edge part 370 may be connected to the outer case main body 362 by being fitted thereto. Accordingly, the outer case main body 362 and the nozzle cover 364 integrally structure the outer case 360 having the substantially cuboid shape. Further, the outer case main body 362, an inner case main body 340, and an attachment plate 342 (described later) define a suction chamber 374 surrounded by the outer case main body 362, the inner case main body 340, and the attachment plate 342. The suction chamber 374 forms a first flow path 903 extending from a plurality of suction ports 366 (described later) to a gas intake port 332. As described above, in the present embodiment, the nozzle cover 364 has the edge part 370; however, in other embodiments, the nozzle cover 364 does not necessarily need to have the edge part 370. In those situations, a lateral wall 363 of the outer case main body 362 extends as far as to the plate part 368.

In an example, the plurality of suction ports 366 each having an oblong hole shape are formed in the plate part 368 (see Fig. 3). Accordingly, the plurality of suction ports 366 allow communication between the outside of the blower unit 300 and the suction chamber 374. As a result, the gas on the outside of the blower unit 300 is able to be drawn into the suction chamber 374 via the plurality of suction ports 366. In this situation, the shape of each of the suction ports 366 does not necessarily have to be the oblong hole shape and may be any other shape such as circular, polygonal, or the like. Further, the suction ports 366 may be formed in any positions in the plate part 368.

In an example, the inner case 320 includes the inner case main body 340, the attachment plate 342 (the second plate) and a fixation plate 343 (see Fig. 2). The inner case main body 340 is a prism-shaped tubular body having an opening closed by the attachment plate 342. Further, the attachment plate 342 is a plate-like member having a plate surface 351 facing the plurality of suction ports 366 formed in the plate part 368. Further, the inner case main body 340 and the attachment plate 342 define a blow chamber 325 surrounded by the inner case main body 340 and the attachment plate 342. The blow chamber 325 forms a second flow path 904 extending from the gas intake port 332 to the plurality of nozzles 420. More specifically, the inner case main body 340 includes a first wall 326, a second wall (the wall) 328, a first inner wall 330, and a second inner wall 331. The first wall 326, the second wall 328, the first inner wall 330, and the second inner wall 331 are each structured with a plate-like member. The first wall 326 faces the fan 302 along the axial direction of the fan 302. The second wall 328 faces the first wall 326 and is positioned closer to the motor 304 than the first wall 326 is. Further, the first inner wall 330 joins the first wall 326 and the second wall 328 together. The second inner wall 331 joins the first wall 326 and the attachment plate 342 together. Further, the gas intake port 332 is formed in the second wall 328. Two outlet ports 334 are formed in the first wall 326(see Fig. 2 and Fig. 5). Further, the space enclosed by the first wall 326, the second wall 328, and the first inner wall 330 is a first blow chamber 322. Further, the space enclosed by the first wall 326, the attachment plate 342, and the second inner wall 331 is a second blow chamber 324. In other words, the first wall 326 divides the blow chamber 325 into the first blow chamber 322 and the second blow chamber 324.

Further, the second blow chamber 324 houses therein the two punching metal pieces 310. Further, the two punching metal pieces 310 extend parallel to the first wall 326. Consequently, the gas blown through the two outlet ports 334 is diffused by the punching metal pieces 310, so that the flow volume is uniform among different positions on a plane perpendicular to the axial direction of the fan 302. As a result, the blower unit 300 is able to supply the gas in more uniform flow volumes to the supply ports 422 respectively corresponding to the plurality of nozzles 420 (described later), compared to the situation where the punching metal pieces 310 are not provided.

As shown in Fig. 6, each of the nozzles 420 is a tubular body having: the supply port 422 through which the gas in the blow chamber 325 is supplied; and a blowing port 424 used for spouting gas to the outside of the blower unit 300. Further, the nozzles 420 are attached to the attachment plate 342. More specifically, each of the nozzles 420 has, as shown in Fig. 6, a main body part 426 and an enlarged diameter part 428 having an outside diameter larger than that of the main body part 426. Further, the attachment plate 342 is provided with a plurality of holes 344 stepped for the purpose of attaching the nozzles 420. The diameter of an opening 346 on the first step of each of the holes 344 corresponds to the outside diameter of the enlarged diameter part 428. The diameter of an opening 348 on the second step of each of the holes 344 corresponds to the outside diameter of the main body part 426. With these arrangements, each of the nozzles 420 is attached to the attachment plate 342 while penetrating the attachment plate 342, as a result of being inserted from the side having the first-step opening 346 in the attachment plate 342. Further, the plurality of nozzles 420 are fixed to the attachment plate 342, as a result of the fixation plate 343 pressing the plurality of nozzles 420 against the attachment plate 342. The fixation plate 343 is provided with holes 345 formed in positions corresponding to the positions of the nozzles 420. As a result, the gas in the blow chamber 325 is supplied to the supply ports 422 of the nozzles 420 via the holes 345. As for the mode of attaching the nozzles 420 to the attachment plate 342, it is possible to adopt any configuration that allows the gas in the blow chamber 325 to be supplied to the supply ports 422. For example, the plurality of nozzles 420 may be welded to the positions where the holes 344 are formed in the attachment plate 342, without going through the holes 344, to allow communication between the supply ports 422 and the holes 344.

Further, the plurality of nozzles 420 go through holes 372 formed in corresponding positions in the nozzle cover 364 of the outer case 360, to allow the blowing ports 424 to communicate with the outside of the outer case 360 (see Fig. 6). Consequently, the blowing ports 424 of the plurality of nozzles 420 are able to spout gas to the outside of the blower unit 300. As for the mode of attaching the nozzles 420 to the nozzle cover 364, it is possible to adopt any configuration that enables the blowing ports 424 of the plurality of nozzles 420 to spout the gas to the outside of the blower unit 300. For example, the plurality of nozzles 420 may be welded to the positions where the holes 372 are formed in the nozzle cover 364, without going through the holes 372, to allow communication between the blowing ports 424 and the holes 372.

Further, in the blower unit 300, the substrate 200 is heated as a result of the gas blown through the blowing ports 424 of the plurality of nozzles 420 coming into contact with the substrate 200 (see Fig. 1). In this situation, the gas blown toward the substrate 200 may bounce back on the substrate 200, so that the gas that bounced back may interfere with the gas that has just been blown toward the substrate 200 through any of the blowing ports 424. In that situation, the gas that bounced back on the substrate 200 has a lower temperature because some heat is taken by the substrate 200. Thus, this situation is not preferable, because the temperature of the gas blown through the blowing ports 424 may be lowered thereby, and also, the blowing directions of the gas blown through the blowing ports 424 may be disturbed thereby.

However, the blower unit 300 is capable of reducing the occurrences where the gas that bounced back on the substrate 200 lowers the temperature of the gas that has just been blown through the blowing ports 424 or disrupts the blowing directions of the gas blown through the blowing ports 424. The reason is that, in the blower unit 300, as shown in Fig. 3, the blowing ports 424 of the plurality of nozzles 420 are positioned adjacent to the suction ports 366. Accordingly, the gas that bounced back on the substrate 200 is immediately drawn through the suction ports 366. As a result, it is possible to reduce the occurrences where the gas that bounced back lowers the temperature of the gas blown through the blowing ports 424 or obstructs the gas blown through the blowing ports 424.

Returning to the description of Fig. 2, the fan 302 is a turbo fan housed in the first blow chamber 322, in an example. The fan 302 is connected to the motor 304 provided on the outside of the outer case 360, via the rotation shaft 306 provided for transmitting rotation. In other words, the rotation shaft 306 extends between the fan 302 and the motor 304, to go through the gas intake port 332. Accordingly, when the motor 304 is driven, the fan 302 rotates and is able to blow the gas in centrifugal directions. Further, wind caused by the rotation of the fan 302 collides with the first inner wall 330 of the inner case main body 340, and the flow direction thereof is changed by the first inner wall 330, to be sent to the second blow chamber 324 through the two outlet ports 334 formed in the first wall 326. Further, the gas sent to the second blow chamber 324 goes through the second blow chamber 324 and is supplied to the plurality of nozzles 420. In other words, as a result of the rotation of the fan 302, the gas flows through the plurality of suction ports 366 toward the plurality of nozzles 420. Thus, the fan 302 has the function of supplying the gas drawn through the plurality of suction ports 366 to the plurality of nozzles 420.

Further, in an example, the heaters 308 are housed in the suction chamber 374 and have a function of heating gas to any temperature. In particular, when the blower unit 300 is used for melting solder like the blower unit 300b provided in the main heating zone B, it is preferable to configure the heaters 308 to have a function of heating the gas to be equal to or higher than 220 degrees. The melting point of lead-free solder contained in the solder paste is approximately 217 degrees, for example. For this reason, the heaters 308, having the function of heating the gas to be equal to or higher than 220 degrees, are able to heat the gas up to a temperature at which the lead-free solder is melted. In other embodiments, the heaters 308 may be provided in other positions such as the inside of the blow chamber 325 or the like. However, as described later, it is preferable to have the heaters 308 positioned between the motor 304 and the fan 302, like the heaters 308a. Accordingly, in the blower unit 300, a part of the heaters 308, such as the heaters 308a, is positioned between the motor 304 and the fan 302 (see Fig. 2). Further, when the blower unit 300 is used for cooling the substrate 200 like the blower unit 300c, the blower unit 300 may include a known cooling unit used for cooling gas, such as a heat exchanger, in place of the heaters 308.

Further, in the blower unit 300, a flow path 905 is formed to extend from the plurality of suction ports 366, to go through the heaters 308 and the fan 302, and to reach the plurality of nozzles 420. The first flow path 903 and the second flow path 904 described above are each a part of the flow path 905. In this situation, as shown in Fig. 4A, a part of the flow path 905 surrounds, without any gap, a peripheral end part 347 of the attachment plate 342, i.e., the entirety of the attachment plate 342 in directions in which the plate surface 351 extends. In other words, a part of the flow path 905 is formed to go through an opening 349 formed between the peripheral end part 347 of the attachment plate 342 and the outer case 360. Accordingly, the blower unit 300 is able to uniformly draw the gas through the plurality of suction ports 366. The reasons thereof will be described below.

As for blower units such as the blower unit 300 including: the plate part 368 in which the plurality of suction ports 366 are formed; and the attachment plate 342 that has the plate surface 351 facing the plurality of suction ports 366, the flow volumes of the gas drawn through the suction ports 366 may be impacted by the structure of the flow path in which the gas drawn through the suction ports 366 flows. For this reason, depending on the structure of the flow path, there is a possibility that the gas may not be uniformly drawn through the plurality of suction ports 366.

For example, like in the heater unit disclosed in PTL 1, when openings are formed in the vicinity of two opposing sides of a rectangular attachment plate, to each extend along a different one of the sides, while the openings serve as flow paths of the gas drawn through a plurality of suction ports, there is a possibility that the gas may not be uniformly drawn through the plurality of suction ports. The reason is that it is easier for the gas to be drawn through suction ports facing the openings formed in the attachment plate and being positioned closer to the openings, while it is more difficult for the gas to be drawn through suction ports facing an intermediate part between any two openings formed in the attachment plate and being positioned farther from each of the openings. In other words, as for travel distances of the gas drawn through the suction ports and traveling from the suction ports to reach the openings, there is a difference in traveling distance between the gas drawn through the suction ports positioned closer to the openings and the gas drawn through the suction ports positioned farther from the openings. Accordingly, the flow volumes of the gas drawn through the suction ports tend to be non-uniform.

In contrast, in the blower unit 300, a part of the flow path 905 surrounds the peripheral end part 347 of the attachment plate 342, i.e., the entirety of the attachment plate 342 (see Fig. 4A). Consequently, the total area of the opening 349 is larger, and the number of positions serving as the opening 349 is also larger, compared to the example described above. As a result, the total volume of the gas drawn through the suction ports 366 positioned farther from the opening 349 is larger, and the difference in travel distance is not easily caused among the gas drawn through the suction ports 366 and traveling from the suction ports 366 to reach the opening 349. As a result, the blower unit 300 is able to uniformly draw the gas through the plurality of suction ports 366.

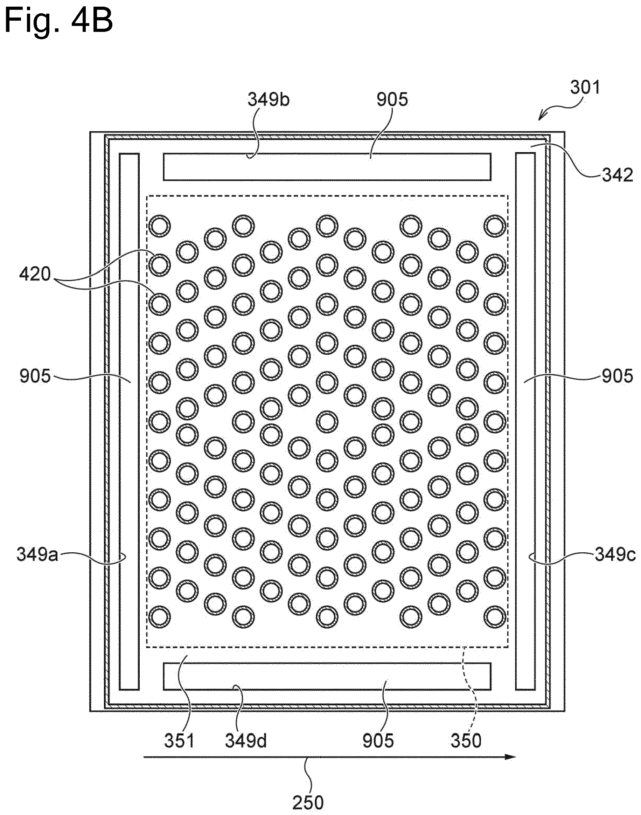

Fig. 4B is a cross-sectional view showing a part of the attachment plate 342 of a blower unit 301 according to another embodiment of the present disclosure. In Fig. 4B, in the vicinity of the four sides of the rectangular attachment plate 342, four rectangular openings 349a, 349b, 349c, and 349d are formed to each extend along a different one of the sides. A part of the flow path 905 is formed to go through the openings 349a, 349b, 349c, and 349d. In other words, a part of the flow path 905 surrounds a partial region 350 of the attachment plate 342 in directions in which the plate surface 351 of the attachment plate 342 extends. In this situation also, as in the blower unit 300 described above, the total area of the openings 349a, 349b, 349c, and 349d is larger, and the number of positions serving as the openings 349a, 349b, 349c, and 349d is also larger, compared to the example disclosed in PTL 1. As a result, as in the blower unit 300, the blower unit 301 is able to uniformly draw the gas through the plurality of suction ports 366. In other words, in order to enable the blower unit 301 to draw the gas through the plurality of suction ports 366 more uniformly than in the example disclosed in PTL 1, it is sufficient when a part of the flow path 905 surrounds at least a part of the attachment plate 342, and there is no need to surround the peripheral end part 347 without a gap. In the present description, the configuration in which a part of the flow path 905 surrounds at least a part of the attachment plate 342 denotes that the flow path 905 is partly positioned at least in the four directions from a certain point within at least a part of the attachment plate 342. More specifically, the configuration denotes that the flow path 905 is partly positioned at least in four positions that are at 90-degree intervals centered on the certain point. Further, in the blower unit 301, in an example, the plurality of nozzles 420 are attached within the area of the region 350 of the attachment plate 342.

Further, as described above, in the blower unit 300, the suction ports 366 may each have any shape and may be arranged in any positions in the plate part 368 (see Fig. 3). However, it is preferable to configure the cross-sectional areas of the suction ports 366 positioned farther from the opening 349 to be larger than the cross-sectional areas of the suction ports 366 positioned closer to the opening 349. In other words, it is preferable to configure the suction ports 366 in such a manner that the cross-sectional area thereof increases, as the distance thereof from the center of the plate part 368 of the nozzle cover 364 becomes shorter. Consequently, in the blower unit 300, the suction ports 366 which are positioned closer to the opening 349 and through which more gas is easily drawn have a larger pressure loss than the suction ports 366 positioned farther from the opening 349. As a result, when the blower unit 300 draws the gas through the plurality of suction ports 366, the plurality of suction ports 366 are able to draw the gas therethrough in a well-balanced manner. Further, in the present description, the distance between each of the suction ports 366 and the opening 349 denotes the distance between the suction port 366 and the opening 349 in the positions closest to each other.

Further, as shown in Fig. 1, in the reflow oven 100, the plurality of blower units 300 are arranged side by side along the transport direction 250 of the substrate 200. In this situation, when the interval between the nozzles 420 belonging to any two blower units 300 positioned adjacent to each other is too long, the gas would not be supplied from the blower units 300 to the substrate 200 for a long period of time. In particular, when the blower units 300 supply the heated gas to the substrate 200, the temperature of the substrate 200 would drop, which is not preferable. To cope with this situation, as shown in Fig. 4A, in the blower units 300, in an example, the opening 349 has a rectangular annular cross-sectional shape, and has two first sections 352 positioned front and back in the transport direction 250 and two second sections 353 positioned left and right in the transport direction 250. In other words, of the opening 349, the first sections 352 are each a section extending in the direction orthogonal to the transport direction 250. Further, of the opening 349, the second sections 353 are each a section extending in the transport direction 250. Further, the dimension of the width L1 of each of the first sections 352 extending in the transport direction 250 is smaller than the dimension of the width L2 of each of the second sections 353 extending in the direction orthogonal to the transport direction 250. With this configuration, in the reflow oven 100, it is possible to arrange the nozzles 420 belonging to any two blower units 300 positioned adjacent to each other so as not to have a long interval therebetween, without decreasing the cross-sectional area of the entirety of the opening 349. As a result, the reflow oven 100 is able to prevent the temperature of the substrate 200 from dropping, by shortening the time period during which no gas is supplied to the substrate 200. Further, in another embodiment, the dimension of the width L1 of each of the first sections 352 extending in the transport direction 250 and the dimension of the width L2 of each of the second sections 353 extending in the direction orthogonal to the transport direction 250 are not particularly limited. For example, the dimension of the width L1 may be equal to the dimension of the width L2 or may be larger than the dimension of the width L2.

Further, in blower units in general, when the flow path structure on the inside becomes complicated so that the flow path meanders or has a narrow cross-sectional area, the pressure loss of the gas flowing through the flow path becomes larger. For this reason, the flow path structure inside blower units is important, and there is a demand for a blower unit of which the design can be detailed, so as not to complicate the flow path structure thereof.

As described above, one of the characteristics of the blower units 300 is that a part of the flow path 905 surrounds the peripheral end part 347 of the attachment plate 342. If the flow path structure of the heater unit disclosed in PTL 1 was applied to the blower units having this characteristic, the flow path structure would be complicated, which is not preferable. The reasons will be described below.

In the heater unit disclosed in PTL 1, as shown in Fig. 12 thereof, gas is supplied from a heat exchange chamber positioned directly below the blower, to a blow chamber. Further, gas is supplied from the blow chamber to blowing nozzles attached to the attachment plate positioned below the heat exchange chamber. Accordingly, in order to apply the flow path structure of the heater unit disclosed in PTL 1 to the blower unit having the abovementioned characteristic, it would be necessary to form a flow path for guiding the gas that has flowed through the surroundings of the peripheral end part of the attachment plate to the heat exchange chamber positioned directly below the blower. If the flow path were formed in this manner, this flow path and the flow path guiding the gas from the blow chamber to the blowing nozzles would compete with each other for the space inside the blower unit, which would make the flow path structure more complicated and would increase the pressure loss.

In contrast, in the blower unit 300 according to the present embodiment, on a cross-sectional plane parallel to the attachment plate 342, the first flow path 903 is positioned to surround the blow chamber 325 (see Fig. 2 and Fig. 5). Consequently, the gas that has passed through the surroundings of the peripheral end part 347 of the attachment plate 342 goes through the first flow path 903, which is positioned to surround the blow chamber 325, and is thus able to flow to reach the gas intake port 332. In this configuration, it is possible to design the part of the first flow path 903 positioned to surround the blow chamber 325, into a shape (e.g., a linear shape) by which little pressure loss is caused. In other words, it is possible to detail the design of the blower units 300 so that the first flow path 903 extending from the plurality of suction ports 366 to the gas intake port 332 does not become complicated. It is therefore possible to reduce the pressure loss in the first flow path 903, which might be caused if the first flow path 903 were complicated.

Further, the solder paste used in the soldering contains a flux. During the soldering, the flux is heated and vaporized. For this reason, the gas inside the reflow oven 100 contains the vaporized flux. Further, while flowing inside the blower unit 300, when the gas containing the flux comes in contact with a member having a low temperature, there is a possibility that the flux may be cooled and may adhere as an adhesive solid to the member having the low temperature.

In the blower units 300, the fan 302 is housed in the first blow chamber 322 positioned on the downstream side of the suction chamber 374 which houses the heaters 308 therein (see Fig. 2). Consequently, the gas drawn into the suction chamber 374 goes through the first flow path 903 and is heated by the heaters 308, before being supplied to the fan 302 housed in the first blow chamber 322. In other words, the gas that has just been heated by the heaters 308 comes into contact with the fan 302. For this reason, because the gas that comes into contact with the fan 302 has a high temperature, the flux contained in the gas is prevented from adhering to the fan 302, in the blower units 300. Further, in the blower units 300, a part of the heaters 308, such as the heaters 308a, is positioned between the motor 304 and the fan 302 (see Fig. 2). Consequently, it is possible to have the heaters 308a positioned close to the rotation shaft 306, which makes it possible to heat the gas in the surroundings of the rotation shaft 306 to a higher temperature. As a result, even when the gas containing the flux comes into contact with the rotation shaft 306, the flux does not get cooled down to a temperature that causes the adhesion. It is therefore possible to prevent the flux from adhering to the rotation shaft 306.

Further, the fan 302 is configured to draw the gas along the axial direction, from the side on which the motor 304 is positioned. Consequently, the gas heated by the heaters 308a flows through the space that is positioned between the motor 304 and the fan 302 and is close to the rotation shaft 306. As a result, because the rotation shaft 306 is warmed by the heated gas, the flux is prevented from adhering to the rotation shaft 306.

### <Operations>

Next, an operation of any of the blower units 300 in the reflow oven 100 will be described, with reference to Fig. 2. When the power source of the blower unit 300 is turned on, the motor 304 is driven, and the fan 302 starts rotating. Thus, the upstream side of the fan 302 has negative pressure. As a result, the gas that is outside the outer case 360 and is inside the reflow oven 100 is drawn into the inside of the outer case 360 through the suction ports 366 (see Fig. 1 and Fig. 2). Subsequently, the drawn gas is heated by the heaters 308, on the inside of the outer case 360.

After that, the gas heated by the heaters 308 is drawn into the inside of the inner case 320 via the gas intake port 332. Subsequently, the gas drawn into the inside of the inner case 320 is blown in centrifugal directions by the fan 302. After that, the gas blown by the fan 302 collides with the first inner wall 330 and is sent to the second blow chamber 324 through the two outlet ports 334. Subsequently, the gas that has passed through the two outlet ports 334 is diffused by the two punching metal pieces 310 and supplied to the supply ports 422 of the nozzles 420. After that, the gas is spouted out through the blowing ports 424 of the nozzles 420. In this manner, the blower units 300 are able to supply the heated wind to the substrate 200. As a result, the reflow oven 100 described above is able to perform the soldering.

### [Supplements]

A part or all of the embodiments described above may also be described as presented in the Supplements below, but is not limited to these examples.

### <Supplement 1>

A soldering device according to Supplement 1 is a soldering device for performing soldering and includes a blower unit for supplying gas to an object, in which the blower unit includes: a first plate in which a plurality of suction ports for drawing of the gas outside the blower unit are formed; a second plate that has a plate surface facing the plurality of suction ports; a plurality of nozzles; and a fan for supplying the gas drawn through the plurality of suction ports to the plurality of nozzles, a flow path through which the gas flows and which extends from the plurality of suction ports to go through the fan and to reach the plurality of nozzles is formed in the blower unit, and a part of the flow path surrounds at least a part of the second plate in directions in which the plate surface extends.

For example, when openings were formed in the vicinity of two opposing sides of the rectangular second plate to each extend along a different one of the sides, so that the openings were to serve as a flow path of the gas drawn through the plurality of suction ports, there would be a possibility that the gas might not be drawn uniformly through the plurality of suction ports. The reason is that it is easier for the gas to be drawn through the suction ports facing the openings formed in the second plate and being positioned closer to the openings, while it is more difficult for the gas to be drawn through the suction ports facing an intermediate part between any two openings formed in the second plate and being positioned farther from each of the openings. In other words, as for the travel distances of the gas drawn through the suction ports and traveling from the suction ports to reach the openings, there is a difference in traveling distance between the gas drawn through the suction ports positioned closer to the openings and the gas drawn through the suction ports positioned farther from the openings. Accordingly, the flow volumes of the gas drawn through the suction ports tend to be non-uniform. In contrast, in the soldering device according to Supplement 1, a part of the flow path surrounds at least a part of the second plate. Consequently, as compared to the example described above, the total area of the opening is larger, and the number of positions serving as the opening is also larger. As a result, the total volume of the gas drawn through the suction ports positioned closer to the opening is larger, and the difference in travel distance is not easily caused among the gas drawn through the suction ports and traveling from the suction ports to reach the opening. As a result, the soldering device is able to uniformly draw the gas through the plurality of suction ports.

### <Supplement 2>

A soldering device according to Supplement 2 is the soldering device according to Supplement 1 in which the blower unit has an outer case including the first plate, and a part of the flow path is formed to go through an opening that is either formed between a peripheral end part of the second plate and the outer case or formed in the second plate.

In the soldering device according to Supplement 2, the gas is able to flow through the opening formed either between the peripheral end part of the second plate and the outer case or in the second plate.

### <Supplement 3>

A soldering device according to Supplement 3 is the soldering device according to Supplement 2 in which the blower unit further includes an inner case main body that has a wall facing the second plate, the inner case main body and the second plate define a blow chamber surrounded by the inner case main body and the second plate; the outer case, the inner case main body, and the second plate define a suction chamber surrounded by the outer case, the inner case main body, and the second plate; a gas intake port for allowing communication between the blow chamber and the suction chamber is formed in the wall; the plurality of nozzles have supply ports through which the gas in the blow chamber is supplied; within the suction chamber, a first flow path being a part of the flow path is formed to extend from the plurality of suction ports to the gas intake port; and on a cross-sectional plane parallel to the second plate, the first flow path is positioned to surround the blow chamber.

In the soldering device according to Supplement 3, the first flow path is positioned to surround the blow chamber, on the cross-sectional plane parallel to the second plate. Consequently, the gas that has passed through the surroundings of the peripheral end part of the second plate goes through the first flow path, which is positioned to surround the blow chamber, and is thus able to flow to reach the gas intake port. In this configuration, it is possible to design the part of the first flow path positioned to surround the blow chamber, into a shape (e.g., a linear shape) by which little pressure loss is caused. In other words, it is possible to detail the design of the soldering device so that the first flow path extending from the plurality of suction ports to the gas intake port does not become complicated. It is therefore possible to reduce the pressure loss in the first flow path, which might be caused if the first flow path were complicated.

### <Supplement 4>

A soldering device according to Supplement 4 is the soldering device according to Supplement 3 in which, within the blow chamber, a second flow path being a part of the flow path is formed to extend from the gas intake port to the plurality of nozzles.

In the soldering device according to Supplement 4, the gas that has passed through the gas intake port is supplied to the plurality of nozzles by going through the second flow path different from the first flow path.

### <Supplement 5>

A soldering device according to Supplement 5 is the soldering device according to any one of Supplements 1 to 4 in which the plurality of nozzles have blowing ports for spouting the gas to an outside of the blower unit, and the blowing ports are positioned adjacent to the suction ports.

As a result of the gas blown through the blowing ports of the plurality of nozzles coming into contact with the substrate, the substrate is heated. On such occasion, the gas blown onto the substrate may bounce back on the substrate, and the gas that bounced back may interfere with the gas that has just been blown onto the substrate through the blowing ports. In that situation, the gas that bounced back on the substrate has a lower temperature because some heat is taken by the substrate, and may, in some situations, lower the temperature of the gas blown through the blowing ports or disrupt the blowing direction of the gas blown through the blowing ports. To cope with these situations, in the soldering device according to Supplement 5, it is possible to reduce the occurrences where the gas that bounced back on the substrate lowers the temperature of the gas that has just been blown through the blowing ports or disrupts the blowing direction of the gas blown through the blowing ports. The reasons is that, in the present soldering device, the blowing ports of the plurality of nozzles are positioned adjacent to the suction ports. Consequently, the gas that bounced back on the substrate is immediately drawn through the suction ports. As a result, it is possible to reduce the occurrences where the gas that bounced back lowers the temperature of the gas blown through the blowing ports or obstructs the gas blown through the blowing ports.

### <Supplement 6>

A soldering device according to Supplement 6 is the soldering device according to any one of Supplements 1 to 5 in which the blower unit further includes a heater for heating the gas.

By using the soldering device according to Supplement 6, it is possible to supply the gas heated by the heater to the object.

### <Supplement 7>

A soldering device according to Supplement 7 is the soldering device according to Supplement 6 in which the blower unit further includes a motor and a rotation shaft for transmitting rotation from the motor to the fan, while the heater is positioned between the motor and the fan.

In the soldering device according to Supplement 7, it is possible to have the heater positioned close to the rotation shaft and to heat the gas in the surroundings of the rotation shaft to a higher temperature. As a result, even when the gas containing a flux comes into contact with the rotation shaft, the flux does not get cooled down to a temperature that causes the adhesion. It is therefore possible to prevent the flux from adhering to the rotation shaft.

### <Supplement 8>

A soldering device according to Supplement 8 is the soldering device according to Supplement 7 in which the fan is configured to draw the gas along an axial direction, from a side on which the motor is positioned.

In the soldering device according to Supplement 8, the gas heated by the heater flows through the space positioned close to the rotation shaft extending between the motor and the fan. Consequently, because the rotation shaft is warmed by the heated gas, it is possible to prevent the flux from adhering to the rotation shaft.

### <Supplement 9>

A soldering device according to Supplement 9 is the soldering device according to any one of Supplements 6 to 8 in which the heater heats the gas to be equal to or higher than 220 degrees.

By using the soldering device according to Supplement 9, it is possible to spout the gas heated by the heater to be equal to or higher than 220 degrees, onto the substrate on which the solder paste has been applied. Further, the melting point of lead-free solder contained in the solder paste is approximately 217 degrees. In other words, the soldering device is able to melt the lead-free solder contained in the solder paste, by using the gas heated by the heater to be equal to or higher than 220 degrees.

### <Supplement 10>

A soldering device according to Supplement 10 is the soldering device according to any one of Supplements 6 to 9 dependent on Supplement 3 or 4 in which the blow chamber houses the fan, and the suction chamber houses the heater.

In the soldering device according to Supplement 10, the fan is housed in the blow chamber positioned on the downstream side of the suction chamber which houses the heater therein. Consequently, the gas heated by the heater housed in the suction chamber is supplied to the fan housed in the blow chamber. In other words, the gas heated by the heater comes into contact with the fan. As a result, because the gas that comes into contact with the fan has a high temperature, the soldering device is able to prevent the flux contained in the gas from adhering to the fan.

### <Supplement 11>

A soldering device according to Supplement 11 is the soldering device according to Supplement 2 or any one of Supplements 3 to 10 dependent on Supplement 2, further including two blower units each being the blower unit and being arranged side by side along a transport direction of the object, two blower units being adjacent to each other, the opening has a rectangular annular cross-sectional shape, and has two first sections positioned front and back in the transport direction and two second sections positioned left and right in the transport direction, and a dimension of a width of each of the first sections extending in the transport direction is smaller than a dimension of a width of each of the second sections extending in a direction orthogonal to the transport direction.

In the soldering device according to Supplement 11, it is possible to arrange the nozzles belonging to any two blower units positioned adjacent to each other so as not to have a long interval therebetween, without decreasing the cross-sectional area of the entirety of the opening. As a result, the soldering device is able to shorten the time period during which no gas is supplied to the substrate.

### <Supplement 12>

A soldering device according to Supplement 12 is the soldering device according to Supplement 2 or any one of Supplements 3 to 10 dependent on Supplement 2 in which, among the plurality of suction ports, cross-sectional areas of suction ports positioned farther from the opening are larger than cross-sectional areas of suction ports positioned closer to the opening.

In the soldering device according to Supplement 12, when the gas is drawn through the plurality of suction ports, the plurality of suction ports are able to draw the gas therethrough in a well-balanced manner.

Embodiments of the present invention and modification examples thereof have thus been described. However, needless to say, the abovementioned examples are intended to facilitate the comprehension of the present invention and are not meant to limit the present invention. It is possible to change or improve the present invention as appropriate without departing from scope of the claims.

### REFERENCE SIGNS LIST

100: REFLOW OVEN
200: SUBSTRATE
300: BLOWER UNIT
302: FAN
304: MOTOR
306: ROTATION SHAFT
308: HEATER
320: INNER CASE
325: BLOW CHAMBER
332: GAS INTAKE PORT
334: OUTLET PORT
340: INNER CASE MAIN BODY
342: ATTACHMENT PLATE (SECOND PLATE)
347: PERIPHERAL END PART
360: OUTER CASE
362: OUTER CASE MAIN BODY
364: NOZZLE COVER
366: SUCTION PORT
368: PLATE PART (FIRST PLATE)
370: EDGE PART
374: SUCTION CHAMBER
420: NOZZLE
422: SUPPLY PORT
424: BLOWING PORT
903: FIRST FLOW PATH
904: SECOND FLOW PATH
905: FLOW PATH

## Claims

1. A soldering device for performing soldering, the soldering device comprising a blower unit (300) for supplying gas to an object, wherein the blower unit includes:
a first plate (368) in which a plurality of suction ports (366) for drawing of the gas outside the blower unit are formed;
a second plate (342) that has a plate surface facing the plurality of suction ports;
a plurality of nozzles (420);
a fan (302) for supplying the gas drawn through the plurality of suction ports (366) to the plurality of nozzles (420), wherein a flow path (905) through which the gas flows and which extends from the plurality of suction ports (366) to go through the fan (302) and to reach the plurality of nozzles (420) is formed in the blower unit (300),
a heater (308) for heating the gas;
a motor (304); and
a rotation shaft (306) for transmitting rotation from the motor (304) to the fan (302),
**characterized in that**
the flow path is partly positioned at least in four positions that are at 90-degree intervals centered on a point within the second plate (342) in directions in which the plate surface extends, and **in that**
the heater (308) is positioned between the motor (304) and the fan (302).

2. The soldering device according to claim 1, wherein
the blower unit has an outer case (362) including the first plate (368) and
a part of the flow path (905) is formed to go through an opening (349) that is either formed between a peripheral end part of the second plate (342) and the outer case (362) or formed in the second plate (342).

3. The soldering device according to claim 2, wherein
the blower unit further includes an inner case main body (340) that has a wall facing the second plate (342),
the inner case main body and the second plate define a blow chamber (325) surrounded by the inner case main body and the second plate,
the outer case, the inner case main body, and the second plate define a suction chamber (374) surrounded by the outer case, the inner case main body, and the second plate,
a gas intake port (332) for allowing communication between the blow chamber and the suction chamber is formed in the wall,
the plurality of nozzles have supply ports (422) through which the gas in the blow chamber is supplied,
within the suction chamber, a first flow path (903) being a part of the flow path is formed to extend from the plurality of suction ports to the gas intake port, and
on a cross-sectional plane parallel to the second plate, the first flow path is positioned to surround the blow chamber.

4. The soldering device according to claim 3, wherein
within the blow chamber, a second flow path (904) being a part of the flow path is formed to extend from the gas intake port to the plurality of nozzles.

5. The soldering device according to any one of claims 1 to 4, wherein
the plurality of nozzles have blowing ports (424) for spouting the gas to an outside of the blower unit, and
the blowing ports are positioned adjacent to the suction ports.

6. The soldering device according to any one of claims 1 to 5, wherein
the fan (302) is configured to draw the gas along an axial direction, from a side on which the motor is positioned.

7. The soldering device according to any one of claims 1 to 6, wherein
the heater heats the gas to be equal to or higher than 220 degrees.

8. The soldering device according to any one of claims 3 or 4, wherein
the blow chamber houses the fan, and
the suction chamber houses the heater.

9. The soldering device according to claim 2 or to any one of claims 3 to 8 when dependent from claim 2, further comprising:
two blower units each being the blower unit and being arranged side by side along a transport direction of the object, the two blower units being adjacent to each other, wherein
the four openings (349) have two first sections positioned front and back in the transport direction and two second sections positioned left and right in the transport direction, and
a dimension of a width of each of the first sections extending in the transport direction is smaller than a dimension of a width of each of the second sections extending in a direction orthogonal to the transport direction.

10. The soldering device according to claim 2 or to any one of claims 3 to 9 when dependent from claim 2, wherein
among the plurality of suction ports (366), cross-sectional areas of suction ports positioned farther from the four openings (349) are larger than cross-sectional areas of suction ports positioned closer to the four openings.

## Patentansprüche

1. Lötvorrichtung zum Ausführen von Lötungen, wobei die Lötvorrichtung eine Gebläseeinheit (300) umfasst, um einem Objekt Gas zuzuführen, wobei die Gebläseeinheit umfasst:
eine erste Platte (368), in der eine Vielzahl von Ansaugöffnungen (366) ausgebildet sind, um das Gas außerhalb der Gebläseeinheit anzusaugen;
eine zweite Platte (342), die eine Plattenoberfläche hat, die zu der Vielzahl von Ansaugöffnungen weist;
eine Vielzahl von Düsen (420);
einen Lüfter (302), um das durch die Vielzahl von Ansaugöffnungen (366) angesogene Gas an die Vielzahl von Düsen (420) bereitzustellen, wobei ein Fließweg (905), den das Gas nimmt und der von der Vielzahl von Ansaugöffnungen (366) durch den Lüfter (302) hin zu der Vielzahl von Düsen (420) verläuft, in der Gebläseeinheit (300) ausgebildet ist,
ein Heizgerät (308) zum Erhitzen des Gases;
einen Motor (304); und
eine Rotationswelle (306) zum Übertragen der Rotation von dem Motor (304) zu dem Lüfter (302),
**dadurch gekennzeichnet, dass**
der Fließweg teilweise mindestens an vier Positionen angeordnet ist, die in 90-Grad-Abständen innerhalb der zweiten Platte (342) in Richtungen, in die sich die Plattenoberfläche erstreckt, um einen Punkt zentriert sind, und dadurch dass
das Heizgerät (308) zwischen dem Motor (304) und dem Lüfter (302) angeordnet ist.

2. Lötvorrichtung nach Anspruch 1, wobei
die Gebläseeinheit ein Außengehäuse (362) aufweist, das die erste Platte (368) einschließt, und
ein Teil des Fließweges (905) dafür ausgebildet ist, durch eine Öffnung (349) zu verlaufen, die entweder zwischen einem peripheren Endteil der zweiten Platte (342) und dem Außengehäuse (362) oder in der zweiten Platte (342) ausgebildet ist.

3. Lötvorrichtung nach Anspruch 2, wobei
die Gebläseeinheit ferner einen Innengehäuse-Hauptkörper (340) umfasst, der eine Wand aufweist, die zu der zweiten Platte (342) weist,
der Innengehäuse-Hauptkörper und die zweite Platte eine Blaskammer (325) definieren, die von dem Innengehäuse-Hauptkörper und der zweiten Platte umschlossen ist,
das Außengehäuse, der Innengehäuse-Hauptkörper und die zweite Platte eine Ansaugkammer (374) definieren, die von dem Außengehäuse, dem Innengehäuse-Hauptkörper und der zweiten Platte umschlossen ist,
eine Gaseintrittsöffnung (332), um eine Kommunikation zwischen der Blaskammer und der Ansaugkammer zu ermöglichen, in der Wand ausgebildet ist,
die Vielzahl von Düsen Zuführöffnungen (422) aufweisen, durch die das Gas in der Blaskammer zugeführt wird,
innerhalb der Ansaugkammer ein erster Fließweg (903), der ein Teil des Fließweges ist, ausgebildet ist, um von der Vielzahl von Ansaugöffnungen zu der Gaszuführöffnung zu verlaufen, und
in einer Querschnittsebene parallel zu der zweiten Platte, der erste Fließweg angeordnet ist, um die Blaskammer zu umgeben.

4. Lötvorrichtung nach Anspruch 3, wobei
innerhalb der Blaskammer ein zweiter Fließweg (904), der ein Teil des Fließweges ist, ausgebildet ist, um von der Gaszuführöffnung zu der Vielzahl von Düsen zu verlaufen.

5. Lötvorrichtung nach einem der Ansprüche 1 bis 4, wobei
die Vielzahl von Düsen Blasöffnungen (424) zur Abgabe des Gases an einen Außenraum der Gebläseeinheit aufweisen, und
die Blasöffnungen angrenzend an die Ansaugöffnungen angeordnet sind.

6. Lötvorrichtung nach einem der Ansprüche 1 bis 5, wobei
der Lüfter (302) dafür konfiguriert ist, das Gas entlang einer axialen Richtung zu fördern, von einer Seite aus, an welcher der Motor angeordnet ist.

7. Lötvorrichtung nach einem der Ansprüche 1 bis 6, wobei das Heizgerät das Gas auf 220 Grad oder mehr erhitzt.

8. Lötvorrichtung nach einem der Ansprüche 3 bis 4, wobei
in der Blaskammer der Lüfter sitzt, und
in der Ansaugkammer das Heizgerät sitzt.

9. Lötvorrichtung nach Anspruch 2 oder nach einem der Ansprüche 3 bis 8, wenn abhängig von Anspruch 2, ferner umfassend:
zwei Gebläseeinheiten, die jede die Gebläseeinheit sind und die nebeneinander entlang einer Transportrichtung des Objekts angeordnet sind, wobei die zwei Gebläseeinheiten aneinander angrenzen, wobei
die vier Öffnungen (349) zwei erste Abschnitte aufweisen, die vorne und hinten in der Transportrichtung angeordnet sind und zwei zweite Abschnitte, die links und rechts in der Transportrichtung angeordnet sind, und
ein Maß einer Breite von jedem der ersten Abschnitte, die in die Transportrichtung verlaufen, kleiner als ein Maß einer Breite von jedem der zweiten Abschnitte, die in eine Richtung senkrecht zur Transportrichtung verlaufen, ist.

10. Lötvorrichtung nach Anspruch 2 oder nach einem der Ansprüche 3 bis 9, wenn abhängig von Anspruch 2, wobei
unter der Vielzahl von Ansaugöffnungen (366) Querschnittsbereiche von Ansaugöffnungen, die weiter entfernt von den vier Öffnungen (349) angeordnet sind, breiter als die Querschnittsbereiche von Ansaugöffnungen sind, die näher an den vier Öffnungen angeordnet sind.

## Revendications

1. Dispositif de brasage pour effectuer un brasage, le dispositif de brasage comprenant une unité soufflante (300) pour fournir du gaz à un objet, dans lequel l'unité soufflante comprend :
une première plaque (368) dans laquelle sont formés une pluralité d'orifices d'aspiration (366) pour aspirer le gaz à l'extérieur de l'unité soufflante ;
une seconde plaque (342) qui présente une surface de plaque faisant face à la pluralité d'orifices d'aspiration ;
une pluralité de buses (420) ;
un ventilateur (302) pour fournir le gaz aspiré à travers la pluralité d'orifices d'aspiration (366) à la pluralité de buses (420), dans lequel un trajet d'écoulement (905) à travers lequel le gaz s'écoule et qui s'étend à partir de la pluralité d'orifices d'aspiration (366) pour passer à travers le ventilateur (302) et pour atteindre la pluralité de buses (420) est formé dans l'unité soufflante (300),
un dispositif de chauffage (308) pour chauffer le gaz ;
un moteur (304) ; et
un arbre de rotation (306) pour transmettre une rotation du moteur (304) au ventilateur (302),
**caractérisé en ce que**
le trajet d'écoulement est partiellement positionné au moins dans quatre positions qui sont à des intervalles de 90 degrés centrées sur un point à l'intérieur de la seconde plaque (342) dans des directions dans lesquelles la surface de plaque s'étend, et **en ce que**
le dispositif de chauffage (308) est positionné entre le moteur (304) et le ventilateur (302).

2. Dispositif de brasage selon la revendication 1,
dans lequel l'unité soufflante présente un boîtier extérieur (362) comprenant la première plaque (368) et
une partie du trajet d'écoulement (905) est formée pour passer à travers une ouverture (349) qui est soit formée entre une partie d'extrémité périphérique de la seconde plaque (342) et le boîtier extérieur (362), soit formée dans la seconde plaque (342).

3. Dispositif de brasage selon la revendication 2, dans lequel
l'unité soufflante comprend en outre un corps principal de boîtier intérieur (340) qui présente une paroi faisant face à la seconde plaque (342),
le corps principal de boîtier intérieur et la seconde plaque définissent une chambre de soufflage (325) entourée par le corps principal de boîtier intérieur et la seconde plaque,
le boîtier extérieur, le corps principal de boîtier intérieur et la seconde plaque définissent une chambre d'aspiration (374) entourée par le boîtier extérieur, le corps principal de boîtier intérieur et la seconde plaque,
un orifice d'admission de gaz (332) pour permettre la communication entre la chambre de soufflage et la chambre d'aspiration est formé dans la paroi,
la pluralité de buses présentent des orifices d'alimentation (422) à travers lesquels le gaz dans la chambre de soufflage est fourni,
à l'intérieur de la chambre d'aspiration, un premier trajet d'écoulement (903) faisant partie du trajet d'écoulement est formé pour s'étendre de la pluralité d'orifices d'aspiration à l'orifice d'admission de gaz, et
sur un plan de section transversale parallèle à la seconde plaque, le premier trajet d'écoulement est positionné pour entourer la chambre de soufflage.

4. Dispositif de brasage selon la revendication 3, dans lequel
à l'intérieur de la chambre de soufflage, un second trajet d'écoulement (904) faisant partie du trajet d'écoulement est formé pour s'étendre de l'orifice d'admission de gaz à la pluralité de buses.

5. Dispositif de brasage selon l'une quelconque des revendications 1 à 4, dans lequel
la pluralité de buses présentent des orifices de soufflage (424) pour déverser le gaz vers l'extérieur de l'unité soufflante, et
les orifices de soufflage sont positionnés adjacents aux orifices d'aspiration.

6. Dispositif de brasage selon l'une quelconque des revendications 1 à 5, dans lequel le ventilateur (302) est configuré pour aspirer le gaz le long d'une direction axiale, à partir d'un côté sur lequel le moteur est positionné.

7. Dispositif de brasage selon l'une quelconque des revendications 1 à 6, dans lequel
le réchauffeur chauffe le gaz pour qu'il soit égal ou supérieur à 220 degrés.

8. Dispositif de brasage selon l'une quelconque des revendications 3 à 4, dans lequel
la chambre de soufflage loge le ventilateur, et
la chambre d'aspiration loge le réchauffeur.

9. Dispositif de brasage selon la revendication 2 ou l'une quelconque des revendications 3 à 8 lorsqu'elles dépendent de la revendication 2, comprenant en outre :
deux unités soufflantes étant chacune l'unité soufflante et étant agencées côte à côte le long d'une direction de transport de l'objet, les deux unités soufflantes étant adjacentes l'une à l'autre, dans lequel les quatre ouvertures (349) présentent deux premières sections positionnées à l'avant et à l'arrière dans la direction de transport et deux secondes sections positionnées à gauche et à droite dans la direction de transport, et
une dimension d'une largeur de chacune des premières sections s'étendant dans la direction de transport est inférieure à une dimension d'une largeur de chacune des secondes sections s'étendant dans une direction orthogonale à la direction de transport.

10. Dispositif de brasage selon la revendication 2 ou l'une quelconque des revendications 3 à 9 lorsqu'elles dépendent de la revendication 2, dans lequel
parmi la pluralité d'orifices d'aspiration (366), les surfaces de section transversale des orifices d'aspiration positionnés plus loin des quatre ouvertures (349) sont plus grandes que les surfaces de section transversale des orifices d'aspiration positionnés plus près des quatre ouvertures.
